# EUROPÄISCHE PATENTSCHRIFT

(11) **EP 0 575 571 B1**
(45) Veröffentlichungstag und Bekanntmachung des Hinweises auf die Patenterteilung: **21.02.1996**
(21) Anmeldenummer: 92924708.8
(22) Anmeldetag: 10.12.1992
(51) Int. Cl.: B60R 16/02

(54) **GEHÄUSE FÜR EIN ELEKTRONISCHES STEUERGERÄT**
HOUSING FOR AN ELECTRONIC CONTROL DEVICE
BOITIER POUR L APPAREIL DE COMMANDE ELECTRONIQUE

(30) Priorität: 09.01.1992 EP 92100275; 09.01.1992 EP 92100277
(43) Veröffentlichungstag der Anmeldung: 29.12.1993
(73) Patentinhaber: SIEMENS AKTIENGESELLSCHAFT, D-80333 München (DE)
(72) Erfinder: PLANKL, Christian, Dipl.-Ing., D-8411 Fussenberg (DE); DIRMAYER, Josef, D-8465 Bodenwöhr (DE); GRUBER, Robert, Dipl.-Ing. (FH), D-8400 Regensburg (DE)
(86) Internationale Anmeldenummer: EP9202856
(87) Internationale Veröffentlichungsnummer: WO9313963

(56) Entgegenhaltungen:
- EP-A- 0 159 125
- WO-A-91/20177
- DE-A- 2 823 666
- DE-A- 3 728 456
- DE-A- 3 833 146
- DE-A- 3 842 160
- US-A- 4 940 420

## Beschreibung

Die Erfindung betrifft ein Gehäuse für ein elektronisches Steuergerät gemäß dem Oberbegriff des Patentanspruchs 1. Ein Beispiel eines solchen Steuergeräts ist ein Airbagsteuergerät für Kraftfahrzeuge.

Ein Steuergerät weist ein Gehäuse auf, in dem ein Schaltungsträger angeordnet ist. Der Schaltungsträger ist mit einem Steckverbinder verbunden. Der Steckverbinder enthält eine Stiftleiste und eine Federleiste. Die Stiftleiste ist mit dem Schaltungsträger und die Federleiste über einen Kabelbaum mit weiteren Steuergeräten elektrisch verbunden.

Aus der WO 91/06 136 ist eine solche Stiftleiste bekannt. An den Seitenwänden der Stiftleiste sind Rastelemente angeordnet. Bei der Montage wird die Stiftleiste durch eine Aussparung des Gehäuses geführt und in die Rastelemente eingerastet. Die Stiftleiste wird mit Schrauben oder Nieten, die durch Bohrungen der Stiftleiste gesteckt sind, an einer eine Schaltung tragenden Leiterplatte befestigt.

Durch das Einrasten der Stiftleiste und durch Toleranzen bei der Fertigung sowohl der Stiftleiste als auch des Gehäuses, liegt die Stiftleiste nicht fest an dem Gehäuse an und ist somit auch nicht fest mit diesem verbunden. Dadurch können Schwingungen von einem mit dem Steckverbinder verbundenen Kabelbaum auf die Leiterplatte übertragen werden und die Funktion der Schaltung stören.

Ferner ist aus der DE-A-37 28 456 ein elektronisches Schalt- und Steuergerät mit mehrreihiger Steckerleiste bekannt, wobei die in zwei Hälften längsgeteilte Steckerleiste in eine Öffnung eines Gehäusedeckels eingebaut und mittels Schrauben am Gehäusedeckel festgeschraubt wird.

Aufgabe der Erfindung ist es, ein Gehäuse für ein elektronisches Steuergerät zu schaffen, bei dem eine Stiftleiste eines Steckverbinders einfach und sicher am Gehäuse des Steuergeräts befestigt ist.

Diese Aufgabe wird erfindungsgemäß durch ein Gehäuse mit den Merkmalen des Patentanspruchs 1 gelöst. Durch eine verformbare Quetschrippe, mit der die Stiftleiste über einem Gehäusesteg an dem Gehäuse befestigt ist, werden bei dem erfindungsgemäßen Gehäuse keine Erschütterungen von einem an den Steckverbinder angeschlossenen Kabelbaum auf das Steuergerät übertragen.

Vorteilhafte Ausgestaltungen der Erfindung sind in den Unteransprüchen gekennzeichnet.

Ein Ausführungsbeispiel der Erfindung ist in der Zeichnung dargestellt und wird im folgenden näher beschrieben.

Es zeigen:
- Figur 1: eine Explosionszeichnung eines erfindungsgemäßen Gehäuses für ein Steuergerät,
- Figur 2: einen Steckverbinder des Steuergeräts, umgeben von einer Gummitülle (teilweise geschnitten), wobei eine Stiftleiste an einem Gehäuse des Steuergeräts befestigt ist,
- Figur 3: eine Seitenansicht der Stiftleiste,
- Figur 4: einen Ausschnitt der Stiftleiste und
- Figur 5: einen Ausschnitt der Stiftleiste, die an dem Gehäuse befestigt ist.

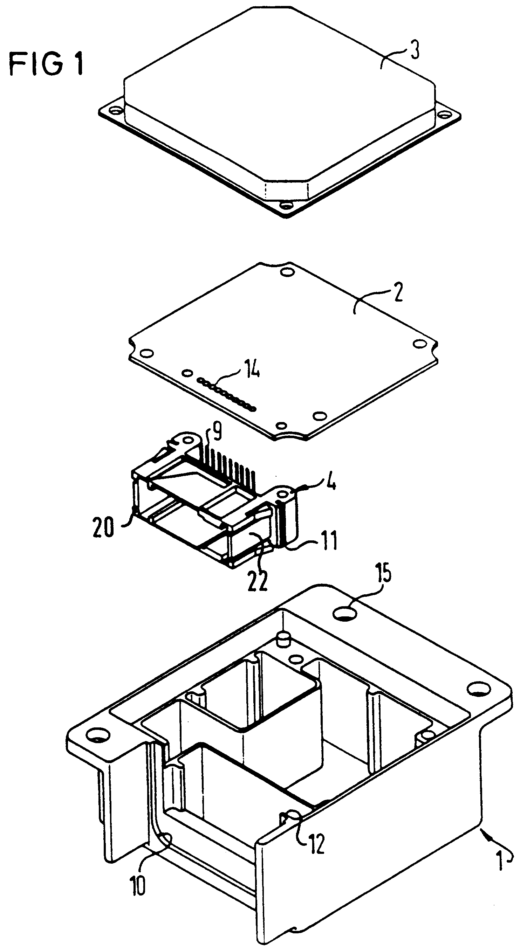

Ein elektronisches Steuergerät, beispielsweise für einen Airbag im Kraftfahrzeug, weist ein Gehäuse 1 (Figur 1), einen Steckverbinder, eine als Schaltungsträger dienende Leiterplatte 2 und einen Deckel 3 auf.

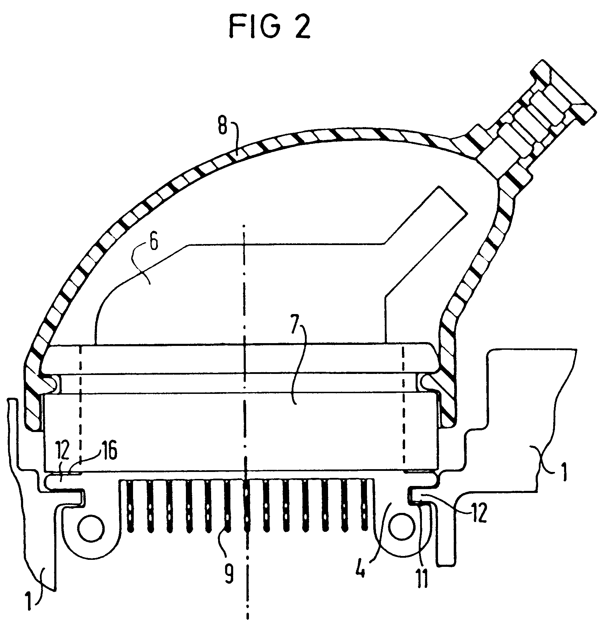

Der Steckverbinder besteht aus einer Stiftleiste 4, einer Federleiste 6 (vgl. Figur 2) sowie je nach Dichtigkeitsanforderung aus einem Abdichtkragen 7 und einer Gummitülle 8. In der Figur 1 ist nur die Stiftleiste 4 des Steckverbinders mit einigen Steckerstiften 9 dargestellt. Die Stiftleiste 4 wird zur Montage des Steuergeräts in einer Aussparung 10 einer Seitenwand des Gehäuses 1 befestigt. Hierzu wird die Stiftleiste 4 mit einer Führungsnut 11 über einen Gehäusesteg 12 geschoben.

Die Leiterplatte 2 mit der nicht dargestellten Schaltung wird anschließend von oben über die Steckerstifte 9 auf der Stiftleiste 4 sowie auf einem Absatz des Gehäuses 1 abgelegt und so auf dem Gehäuses 1 befestigt, daß die Leiterplatte 2 das Gehäuseinnere nach oben hin abdeckt und sich im Gehäuseinneren mehrere abgeschlossene Kammern bilden.

Nach der Montage der Leiterplatte 2 ragen die Steckerstifte 9 aus Bohrungen 14 der Leiterplatte 2 heraus. Die Steckerstifte 9 werden anschließend zusammen mit den nicht dargestellten Bauelementen der Schaltung auf bekannte Weise gelötet. Zum Schluß wird das Gehäuse 1 mit dem Deckel 3, der auf dem Gehäuse 1 befestigt wird, verschlossen. Das Steuergerät kann danach beispielsweise im Motorraum eines Kraftfahrzeugs durch Befestigungsbohrungen 15 des Gehäuses 1 montiert werden.

Um das Gehäuse 1 im Bereich der Aussparung 10, in der die Stiftleiste 4 angeordnet ist, abzudichten, ist ein Abdichtkragen 7 (Figur 2) von außen bis zu einem Anschlag 16 über die Stiftleiste 4 geschoben. In Figur 2 ist eine Draufsicht des Steuergeräts mit komplettem Steckverbinder bei geschnittener Gummitülle 8 dargestellt. Das Gehäuse 1 und die Leiterplatte 2 sind nur schematisch dargestellt.

Die Federleiste 6 bildet den Gegenstecker zur Stiftleiste 4 und wird durch ein Kontaktverriegelung, die in der Zeichnung nicht dargestellt ist, an der Stiftleiste 4 verankert. An die Federleiste 6 ist ein nicht dargestellter Kabelbaum angeschlossen. Hiermit wird das Steuergerät mit weiteren nicht dargestellten, elektrischen Einrichtungen im Kraftfahrzeug verbunden.

Wenn die Steckerstifte 9 innerhalb der Stiftleiste 4 nicht jeweils einzeln abgedichtet sind, dann wird die Gummitülle 8 benötigt, die den Abdichtkragen 7 sowie den Kabelbaum bei der Kabeleinführung zu der Federleiste 6 eng umschließt und den gesamten Steckverbinder abdichtet.

Die Führungsnut 11 dient zum Befestigen der Stiftleiste 4 am Gehäuse 1. Um die Stiftleiste 4 fest mit dem Gehäuse 1 zu verbinden, ist längs der Führungsnut 11 eine verformbare Quetschrippe 25 angeordnet. Diese wird gequetscht oder verformt sich, wenn die Stiftleiste 4 über den Gehäusesteg 12 gedrückt und geschoben wird. Die Stiftleiste 4 ist dann an dem Gehäusesteg 12 festgeklemmt.

Fertigungstoleranzen, die bei der Herstellung des Gehäuses 1 und des Leistenkörpers 20 entstehen, können somit durch das Verformen der Quetschrippe 25 ausgeglichen werden.

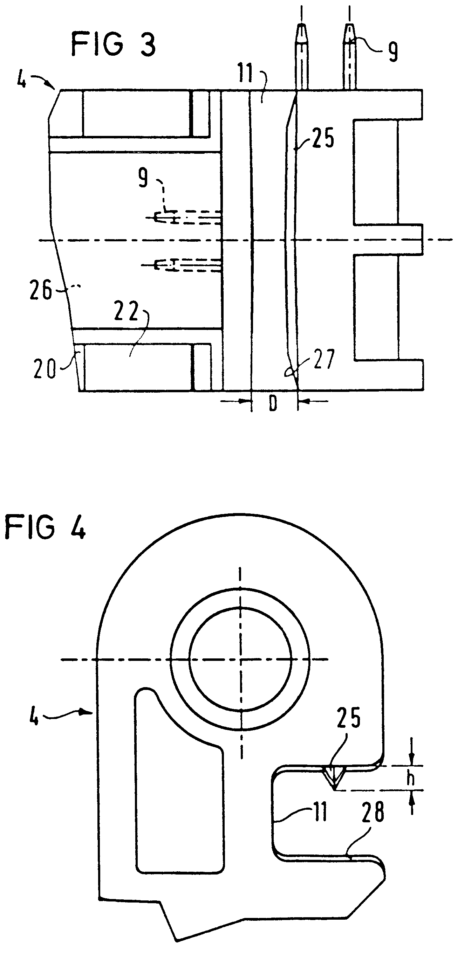

Die Führungsnut 11 (Figur 3) erstreckt sich ihrer Länge nach über die gesamte Breite der Seitenwand des Leistenkörpers 20. Die Führungsnut 11 hat eine Breite D. Die Breite D muß größer sein als die Breite des Gehäusestegs 12, damit die Stiftleiste 4 über dem Gehäusesteg 12 befestigt werden kann.

Die Quetschrippe 25 (Figur 3) kann sich über die gesamte Länge der Führungsnut 11 erstrecken. Sie weist eine Einführschräge 27 auf, um das Einschieben in den Gehäusesteg 12 zu erleichtern. Außer im Bereich der Einführschräge 27 ist ihre Höhe h (vgl. hierzu Figur 4) über ihre gesamte Länge in etwa gleichbleibend. Als Höhe h wird die ursprüngliche Höhe der Quetschrippe 25 bezeichnet, bevor die Stiftleiste 4 an dem Gehäuse 1 befestigt ist und folglich die Quetschrippe 25 verformt ist.

Der Leistenkörper 20 weist außerdem eine zur Rückseite offene Kammer 26 (Fig.3) Aufnahme der Federleiste 6 auf. Die parallelen, in einem Raster angeordneten Steckerstifte 9 gehen durch den Boden der Kammer 26 und ragen einerseits zur Vorderseite des Leistenkörpers 20 heraus und andererseits zur Rückseite in die Kammer 26 hinein.

In der Zeichnung sind die Steckerstifte 9 um 90° nach oben abgewinkelt. Sie können ebenso gut um 90° nach unten oder nicht abgewinkelt sein.

In Figur 4 ist ein Ausschnitt der Stiftleiste 4 als Detail stark vergrößert dargestellt. Die Quetschrippe 25 ist bei diesem Ausführungsbeispiel keilförmig ausgebildet.

Die Führungsnut 11 kann x-förmig ausgebildet sein, d.h. sie kann eine Entformungsschräge 28 (Fig.4) aufweisen, die das Entfernen des Leistenkörpers 20 aus dem Formwerkzeug erleichtert, nachdem der Leistenkörper 20 spritzgegossen ist. Dann hat die Führungsnut 11 in der Mitte die kleinste Breite D und ihre Breite D vergrößert sich zu ihren Enden hin (andeutungsweise auch in Figur 3 dargestellt). Die Entformungsschräge 28 hat gegenüber der Führungsnut 11 ohne Entformungsschräge einen Neigungswinkel von vorzugsweise 1°.

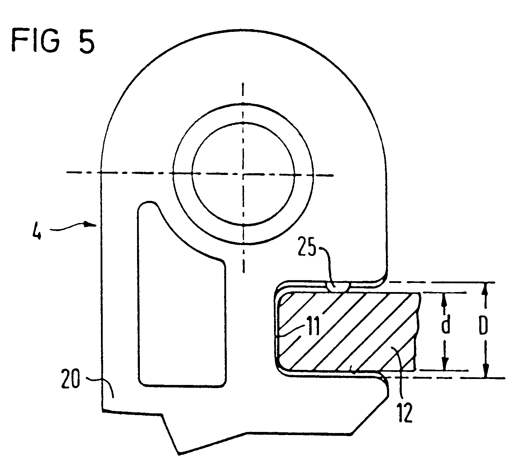

Wenn die Stiftleiste 4 mit ihrer Führungsnut 11 über einen Gehäusesteg 12 geschoben ist (Figur 5), so verformt sich die Quetschrippe 25 und klemmt den Gehäusesteg 12 in der Führungsnut 11 ein. Damit die Quetschrippe 25 gerade noch verformt wird, muß die Höhe h der Quetschrippe 25 größer sein als die minimale Breite D der Führungsnut 11 abzüglich der Breite d des Gehäusestegs 12.

Die Höhe h der Quetschrippe 25 darf allerdings nicht zu klein sein, da ansonsten nur eine geringe Klemmwirkung erreicht wird. Sie darf aber auch nicht zu groß sein, damit das Einschieben der Stiftleiste 4 in den Gehäusesteg 12 nicht zu sehr erschwert wird. Bei diesem Ausführungsbeispiel beträgt die kleinste Breite D etwa 2,5 mm und die Höhe h etwa 0,5 mm bei einer Breite d von etwa 2,3 mm.

Damit die Stiftleiste 4 sicher an dem Gehäuse 1 befestigt werden kann, weist sie - wie in den Figuren dargestellt - zwei Führungsnuten 11 auf, die über zwei Gehäusestege 12 gesteckt werden.

Die Stiftleiste 4 kann auch statt der Führungsnut 11 einen nicht dargestellten Führungssteg mit einer Quetschrippe aufweisen. Dann muß das Gehäuse 1 eine Gehäusenut aufweisen, in die die Stiftleiste 4 mit dem Führungssteg und der Quetschrippe geschoben wird und somit die Stiftleiste 4 an dem Gehäuse 1 befestigt wird.

In diesem Fall muß die Höhe h der Quetschrippe 25 größer sein als die Breite des Führungsstegs abzüglich der Breite der Gehäusenut.

Zum verbesserten Halt der Stiftleiste 4 kann jeweils eine Quetschrippe 25 auch an jeder Seitenwand der Führungsnut 11 bzw. des Führungsstegs angeordnet sein.

## Patentansprüche

1. Gehäuse (1) für ein elektronisches Steuergerät, insbesondere für ein Kraftfahrzeug, in dem ein Schaltungsträger (2) und eine Stiftleiste (4), die in einer Aussparung (10) des Gehäuses (1) angeordnet ist, enthalten sind, wobei die Stiftleiste (4) einen aus Isolierstoff hergestellten Leistenkörper (20) aufweist,
**dadurch gekennzeichnet, daß**
der Leistenkörper (20) an mindestens einer Seitenwand eine Führungsnut (11) oder einen Führungssteg mit jeweils einer verformbaren Quetschrippe (25) aufweist, deren Höhe h größer ist als die Differenz der Breite D der Führungsnut (11) bzw. des Führungsstegs und der Breite d eines Gehäusestegs (12) bzw. einer Gehäusenut, wobei die Quetschrippe (25) verformt ist, wenn die Stiftleiste (4) mit der Führungsnut (11) bzw. dem Führungssteg über den Gehäusesteg (12) bzw. in die Gehäusenut gesteckt ist und somit an dem Gehäuse (1) befestigt ist.

2. Gehäuse nach Anspruch 1, dadurch gekennzeichnet, daß die Quetschrippe (25) eine Einführschräge (27) aufweist, durch die das Einschieben der Stiftleiste (4) über den Gehäusesteg (12) oder in die Gehäusenut erleichtert wird.

3. Gehäuse nach Anspruch 1 oder 2, dadurch gekennzeichnet, daß die Quetschrippe (25) sich über die gesamte Länge der Führungsnut (11) oder des Führungsstegs erstreckt.

## Claims

1. Housing (1) for an electronic control device, in particular for a motor vehicle, in which there are contained a circuit carrier (2) and a plug connector (4), which is arranged in a recess (10) of the housing (1), the plug connector (4) having a plug body (20) which is produced from insulating material, characterized in that the connector body (20) has, on at least one side wall, a guide groove (11) or a guide web with in each case a deformable compression rib (25) of which the height h is greater than the difference between the width D of the guide groove (11) or of the guide web and the width d of a housing web (12) or of a housing groove, the compression rib (25) being deformed when the plug connector (4) with the guide groove (11) or the guide web is pushed over the housing web (12) or into the housing groove and is thus secured to the housing (1).

2. Housing according to Claim 1, characterized in that the compression rib (25) has an insertion bevel (27) by means of which pushing the plug connector (4) over the housing web (12) or into the housing groove is facilitated.

3. Housing according to Claim 1 or 2, characterized in that the compression rib (25) extends over the entire length of the guide groove (11) or of the guide web.

## Revendications

1. Boîtier (1) d'un appareil électronique de commande, destiné notamment à un véhicule automobile, comprenant un support (2) de circuit et une réglette (4) à broches, qui est montée dans un évidement (10) du boîtier (1), la réglette (4) à broches comprenant un corps (20) fabriqué en un matériau isolant,
caractérisé en ce que
le corps (20) de réglette comporte sur au moins une paroi latérale une rainure (11) de guidage ou une barrette de guidage comportant une nervure (25) à écraser, qui peut être déformée et dont la hauteur (h) est plus grande que la différence entre la largeur (D) de la rainure (11) de guidage ou de la barrette de guidage et la largeur (d) d'une barrette (12) du boîtier ou d'une rainure du boîtier, la nervure (25) à écraser étant déformée, lorsque la réglette (4) à broches est enfichée par la rainure (11) de guidage ou par la barrette de guidage sur la barrette (12) du boitier ou dans la rainure du boîtier et étant ainsi fixée au boitier (1).

2. Boîtier suivant la revendication 1, caractérisé en ce que la nervure (25) à écraser comporte un biseau (27) d'introduction, qui facilite l'insertion de la réglette (4) à broches sur la barrette (12) du boitier ou dans la rainure du boîtier.

3. Boîtier suivant la revendication 1 ou 2, caractérisé en ce que la nervure (25) à écraser s'étend sur toute la longueur de la rainure (11) de guidage ou de la barrette de guidage.
